Europäisches Patentamt

European Patent Office

Office européen des brevets

(11) Numéro de publication: **0 321 046**
**A1**

## (12) DEMANDE DE BREVET EUROPEEN

(21) Numéro de dépôt: **88202850.9**

(22) Date de dépôt: **13.12.88**

(51) Int. Cl.4: **H03F 3/60**

(30) Priorité: **18.12.87 FR 8717712**

(43) Date de publication de la demande:
**21.06.89 Bulletin 89/25**

(84) Etats contractants désignés:
**DE FR GB IT**

(71) Demandeur: **Laboratoires d'Electronique et de Physique Appliquée L.E.P.**
**3, Avenue Descartes**
**F-94450 Limeil-Brévannes(FR)**

(84) **FR**

Demandeur: **N.V. Philips' Gloeilampenfabrieken**
**Groenewoudseweg 1**
**NL-5621 BA Eindhoven(NL)**

(84) **DE GB IT**

(72) Inventeur: **Gamand, Patrice**
**Société Civile S.P.I.D. 209 rue de l'Université**
**F-75800 Paris(FR)**

(74) Mandataire: **Landousy, Christian et al**
**Société Civile S.P.I.D. 209, Rue de l'Université**
**F-75007 Paris(FR)**

(54) **Circuit hyperfréquences comprenant au moins un transistor à effet de champ chargé.**

(57) Circuit hyperfréquences comprenant au moins un transistor à effet de champ, constitué, en contact avec une zone active, d'électrodes de grille, de drain et de source, l'électrode de grille recevant un signal d'entrée hyperfréquences, et les électrodes de source et drain fournissant des signaux de sortie hyperfréquences, les électrodes de grille et de drain étant en outre munies de circuits de polarisation et de charge, et l'électrode de source étant reliée à la masse à travers une charge, caractérisé en ce que, les signaux hyperfréquences sont appliqués ou disponibles à une extrémité de leurs électrodes respectives, lesquelles sont par ailleurs fermées à leur seconde extrémité par leurs circuits de polarisation ou de charge respectifs.

Le transistor à effet de champ peut être avantageusement un transistor à grille et drain interdigités.

FIG.1a

## CIRCUIT HYPERFREQUENCES COMPRENANT AU MOINS UN TRANSISTOR A EFFET DE CHAMP CHARGE

L'invention concerne un circuit hyperfréquences comprenant au moins un transistor à effet de champ, constitué, en contact avec une zone active, d'électrodes de grille, de drain et de source, l'électrode de grille recevant un signal d'entrée hyperfréquences, et les électrodes de source et drain fournissant des signaux de sortie hyperfréquences, les électrodes de grille et de drain étant en outre munies de circuits de polarisation et de charge, et l'électrode de source étant reliée à la masse à travers une charge.

L'invention trouve son application dans la réalisation d'étages amplificateurs ou oscillateurs dans le domaine des hyperfréquences.

Un circuit hyperfréquences tel que décrit dans le préambule est connu de la publication intitulée "A fully-Integrated, 0.5.W., 2 to 6 GHz MMIc amplifier", par B.MAOZ et alii, lors de "17th European Microwave Conference, Ergife Palace Hotel, Rome, Italy, 7th - 11th September 1987", dans "Conference Proceedings Microwave exhibitions and Publishers LTD, pp.261-266".

Cette publication décrit un amplificateur intégré, formé de deux étages. Chaque étage comprend un transistor à effet de champ, à grille interdigitée. La grille est donc formée de plusieurs doigts réunis à une extrémité à un plot de contact de grille, de grande surface, et sur lequel est appliqué à la fois le signal hyperfréquences d'entrée de l'étage et un circuit de polarisation de type LC. Le drain est également formé de plusieurs doigts, alternés avec les doigts de grille, réunis à leur extrémité opposée au plot de grille, à un plot de contact de drain, de grande surface, sur lequel est appliqué un circuit de polarisation de type LC et est prélevé le signal hyperfréquences de sortie de l'étage. La source est directement portée à la masse.

Tel qu'il est conçu, cet amplificateur admet, pour chaque étage, un gain maximal qui est inférieur ou égal à celui d'un transistor non chargé identique à celui qui le constitue.

La présente invention a pour but principal de fournir un circuit comprenant au moins un transistor à effet de champ, chargé, présentant, au contraire un gain maximal qui est supérieur à celui d'un transistor identique non chargé.

Selon l'invention ce but est atteint au moyen d'un circuit tel que décrit dans le préambule et caractérisé en ce que, les signaux hyperfréquences sont appliqués ou disponibles à une extrémité de leurs électrodes respectives, lesquelles sont par ailleurs fermées, à leur seconde extrémité, par leurs circuits de polarisation ou de charge respectifs.

Le circuit selon l'invention présente alors pour chaque étage à transistor à effet de champ chargé, un gain supérieur à celui d'un même transistor non chargé.

En outre le circuit selon l'invention peut fonctionner à de très hautes fréquences, et sur une large bande de fréquences.

L'invention sera mieux comprise au moyen de la description suivante illustrée par les figures schématiques annexées dont :

- la figure 1a qui représente, vu du dessus, un étage amplificateur selon l'invention, comprenant un transistor à effet de champ à électrodes de grille et drain interdigitées ;

- la figure 1b qui représente, en trait plein, sur la courbe A, le gain maximal du transistor chargé, dans une mise en oeuvre de l'étage de la figure 1a, et en trait discontinu, sur la courbe B, le gain maximal du même transistor lorsqu'il n'est pas chargé, ou lorsqu'il est chargé selon l'art antérieur ;

- la figure 2 qui représente, vu du dessus, un étage amplificateur selon l'invention, comprenant un transistor à effet de champ à un doigt de grille ;

- la figure 3a, qui représente une variante de l'étage amplificateur selon l'invention.

- la figure 3b qui représente un étage amplificateur réalisé au moyen d'un transistor du type de celui de la figure 3a, chargé selon l'invention ;

- la figure 3c qui représente en trait continu le gain d'un amplificateur selon la figure 3b, et en trait discontinu le gain d'un amplificateur selon l'art antérieur, en fonction de la fréquence,

- les figures 4 qui représentent les variations des paramètres $S_{11}$, K, $S_{12}$, $S_{21}$ et du MAG en fonction de $L_{21}$, pour un transistor chargé conformément à l'invention (trait continu) et pour un transistor non chargé ou chargé selon l'art antérieur (trait discontinu).

Le transistor à effet de champ chargé réalisé selon l'invention, peut être utilisé pour mettre en oeuvre des étages amplificateurs, ou bien des étages oscillateurs, ou encore des mélangeurs, des limiteurs de tension, etc, tant en basses fréquences qu'en hyperfréquences.

Les caractéristiques pour passer d'un type de circuit à l'autre sont connues par ailleurs de l'homme du métier et ne font pas, à proprement parler, partie de l'invention. C'est pourquoi, il sera décrit ici à titre d'exemple, seulement des étages amplificateurs.

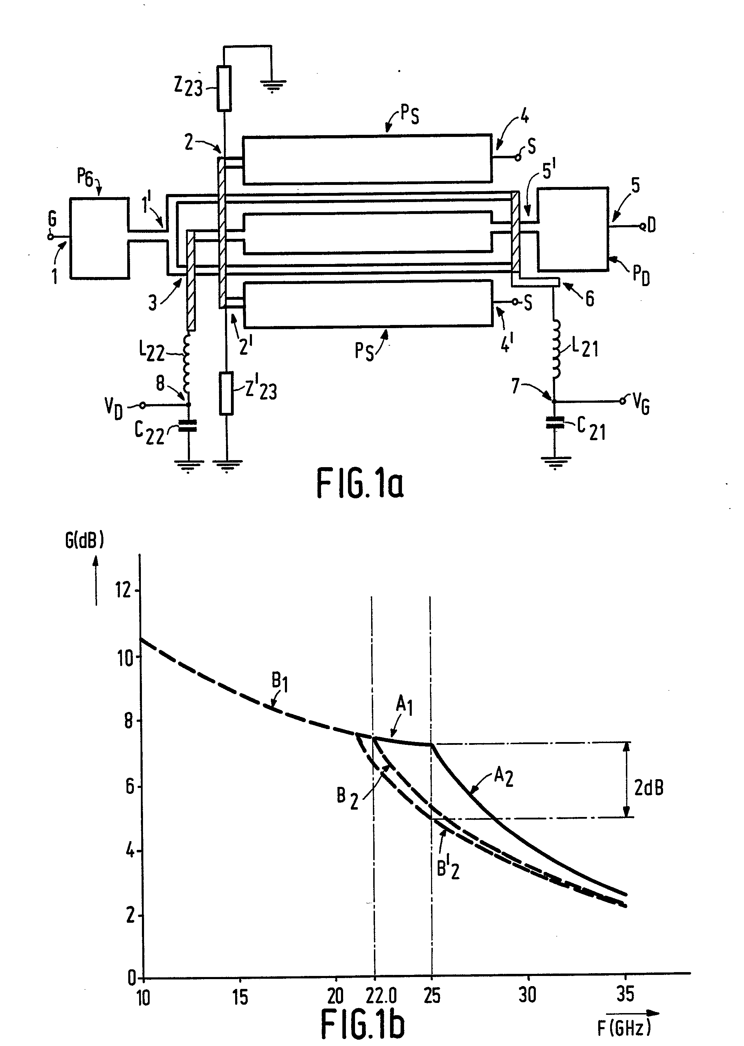

Tel que représenté sur la figure 1a, un étage amplificateur réalisé selon l'invention, comprend d'abord un transistor à effet de champ. Ce dernier est constitué d'une zone active, par exemple de type de conductivité n, réalisée en surface d'un substrat semi-isolant. Sur cette zone active, sont réalisées une électrode de grille G, ayant la forme de deux doigts réunis à une extrémité $1'$ et connectés par cette extrémité à un plot $P_G$ de grande surface, et une électrode de drain en forme de doigt, disposée entre les deux doigts de grille et reliée par l'extrémité $5'$ opposée au plots $P_G$, à un plot $P_D$ de grande surface. Sur la zone active, sont également réalisés deux plots de source Ps, de forme alongée, disposés de part et d'autre des doigts de grille entre les points 2 et 4, et entre les points $2'$ et $4'$ respectivement.

Pour mettre en oeuvre la réalisation d'un tel transistor, on lira avec profit la revue "ACTA ELECTRONICA, Vol. 23, 2, 1980 p.99-109 ; Vol. 23, 1, 1980 p. 64 ; Vol. 23, 2, 1980 p. 116-117 ; Vol. 23, 2, 1980, P. 123-124 ; et pour un enseignement général concernant les transistors à effet de champ en arséniure de gallium l'ensemble du Vol. 23, 1980 de cette revue.

Les doigts de grille peuvent être par exemple des électrodes de type Schottky, et les source et drain des électrodes de type ohmique.

Les performances d'un transistor à effet de champ dépendent essentiellement de sa largeur de grille notée L, et de sa longueur de grille notée $\ell$.

Mais dans les circuits hyperfréquences cités plus haut, comme dans les amplificateurs, la principale caractéristique du circuit est son gain maximal disponible (M.A.G), et le principal problème à résoudre est l'obtention d'un gain aussi grand que possible, dans une bande de fréquence aussi large que possible.

Le gain d'un transistor à effet de champ peut être calculé à partir des paramètres $S_{ij}$ qui sont les coefficients de réflexion aux entrées et sorties, ou les coefficients de transfert entre les entrées et sorties du transistor considéré comme un quadripole. On lira à ce sujet "ACTA ELECTRONICA Vol. 23, 2, 1980 pp. 137-140.

On définit également un coefficient de stabilité K du quadripole, qui est exprimé dans la relation 1 du tableau I.

Si K > 1, le transistor est dit inconditionnellement stable ; dans le cas contraire, où K < 1, le transistor est potentiellement instable.

Lorsque K > 1, on définit le gain maximal disponible (en abrégé MAG) qui est exprimé dans la relation 2 du tableau I, sinon on définit le gain stable maximal (en abrégé MSG) qui est exprimé dans la relation 3 du tableau I.

La figure 1b montre, pour la forme de transistor à effet de champ représenté sur la figure 1a, une évolution du gain G maximal du transistor non chargé (courbe B en traits discontinus), en fonction de la fréquence F.

La première partie de la courbe B notée $B_1$) représente la partie où K < 1 (MSG) et la seconde partie de la courbe la partie où K > 1 (MAG).

Si l'on considère un étage amplificateur tel que celui décrit dans l'état de la technique "Conference Proceedings 1987 pp. 261-266" déjà cité, étage amplificateur comprenant un transistor à effet de champ dont la grille et le drain sont respectivement polarisés à travers une inductance appliquée sur leur plot de contact de grande surface, inductance par ailleurs reliée à la masse à travers une capacité d'isolement, il s'avère que le gain maximal disponible (MAG) est inférieur au gain du transistor non chargé, et que le gain stable maximal (MSG) est seulement égal.

Donc, si l'on traçait la courbe de gain maximal du transistor de la figure 1a, sur la figure 1b, en appliquant pour réaliser les circuits de polarisation, l'enseignement du document cité, on obtiendrait une portion de courbe $B_1$ identique (cas où K < 1 et MSG identique) et une portion de courbe $B'_2$ située sous la courbe $B_2$ déjà représentée, et plus rapprochée de l'axe portant les fréquences (cas où K > 1 et MAG inférieur à celui du transistor non chargé).

Les courbes B de la figure 1b montrent bien que le circuit connu du document cité ne peut fournir un gain supérieur à celui d'un transistor identique non chargé.

Au contraire, le circuit selon l'invention permet d'obtenir un gain maximal de l'étage amplificateur qui est supérieur au gain maximal de ce même transistor non chargé. De plus, le circuit selon l'invention permet d'obtenir une telle augmentation de gain dans le domaine des très hautes fréquences (généralement supérieures 20 ou 22 GHz) et sur une très large bande de fréquences. Enfin le circuit ainsi réalisé selon l'invention présente une meilleure adaptation de l'entrée et de la sortie que le circuit connu de l'état de la technique.

Selon l'invention, on augmente le MAG de l'étage par la prise en compte des caractéristiques intrinsèques de la grille (voir à ce sujet ACTA ELECTRONICA Vol. 23, 1, 1980, pp. 78-79), chargée par l'inductance connectée à son extrémité opposée au plot de grille. Le but atteint par le circuit selon l'invention est une augmentation du coefficient de réflexion $S_{11}$ à l'entrée du circuit considéré comme un quadripole. L'augmentation de $S_{11}$ entraîne une diminution du coefficient de stabilité K, ce coefficient intervenant directement dans la relation (2) du tableau I donnant le gain MAG.

En définissant $S_{21}$ comme le paramètre de transfert de l'entrée vers la sortie du quadripole, et $S_{12}$ comme le paramètre de transfert de la sortie vers l'entrée, il apparaît dans cette relation (2) que :

- à rapport $S_{21}/S_{12}$ constant, la diminution de la valeur de K fait augmenter la valeur du MAG.

Or, lorsque deux circuits chargés différemment, sont néanmoins réalisés à partir d'un transistor identique, le rapport $S_{21}/S_{12}$ reste identique de l'un à l'autre circuit. Donc l'obtention d'une diminution de K permet d'augmenter le MAG, et donc d'obtenir les courbes $A_1$ et $A_2$ sur la figure 1b.

Les buts de l'invention sont atteints au moyen du dispositif représenté entre autres sur la figure 1a.

Le signal d'entrée hyperfréquences I est appliqué au point 1 sur le plot de grille $P_G$. Le signal de sortie hyperfréquences 0 est disponible au point 5 sur le plot de drain $P_D$.

Selon l'invention, les extrémités 6 de la grille opposées au plot $P_G$ sur lequel est appliqué le signal d'entrée hyperfréquences I, ne sont plus laissées en circuit ouvert comme selon l'art antérieur, non plus que l'extrémité 3 du drain opposée au plot $P_D$ sur lequel est disponible le signal de sortie hyperfréquences 0, mais sont au contraire fermées sur des charges inductives, de manière à compenser les capacités d'entrée-sortie du transistor.

De cette manière, on utilise la structure résistive de la grille pour obtenir le dispositif selon l'invention, lequel présente un MAG supérieur à celui d'un transistor identique non chargé, ou chargé de façon connue.

Tel que représenté sur la figure 1a, les extrémités 6 des deux doigts de grille sont réunies, par exemple par une interconnexion réalisée à un second niveau, à la connexion 5' qui est établie entre le doigt de drain et le plot de drain $P_D$. Cette extrémité 6 est fermée sur l'inductance $L_{21}$, à l'autre extrémité de laquelle est appliquée au point 7 la tension continue de polarisation $V_G$. De plus, au point 7, l'inductance $L_{21}$ est reliée à la masse à travers une capacité d'isolement $C_{21}$.

L'extrémité 3 du drain, opposée au plot $P_D$, est fermée, par exemple par une interconnexion réalisée à un second niveau, sur l'inductance $L_{22}$, à l'autre extrémité de laquelle est appliquée, au point 8, une tension continue de polarisation $V_D$. De plus, au point 8, l'inductance $L_{22}$ est reliée à la masse à travers une capacité d'isolement $C_{22}$.

La structure de la figure 1a permet d'appliquer directement les tensions de polarisation de grille et de drain pour faire fonctionner le dispositif, sans que d'autres éléments de circuit soient nécessaires.

Les inductances $L_{21}$ et $L_{22}$ peuvent être remplacées pour différentes applications par des lignes microrubans ou des circuits comportant des lignes microrubans associées à des lignes ouvertes ou court-circuitées.

Enfin, les extrémités 2 et 2' des plots de source $P_S$ sont reliées entre elles, par exemple par une interconnexion à un second niveau, et sont respectivement fermées sur une impédance $Z_{23}$ et $Z'_{23}$ placées entre les points respectivement 2 et 2' et la masse. Les charges $Z_{23}$ et $Z'_{23}$ seront avantageusement égales, et de la forme de la relation (4) du tableau I. Si Y = 0, l'impédance Z est purement résistive. Si Y < 0, l'impédance Z comprend une capacité et si Y > 0 cette impédance comprend une inductance. Le signal hperfréquences de source peut être prélevé soit au point 4 soit en 4', aux extrémités opposées des plots de source $P_S$.

L'étage comportant un transistor à grille et drain interdigités sur lequel les circuits de polarisation et de charge sont appliqués selon la présente invention, constitue un amplificateur hyperfréquences et large bande.

Dans un exemple de réalisation, l'étage selon l'invention, tel que montré sur la figure 1a, est réalisé sur un substrat en arséniure de gallium (GaAs) semi-isolant. La zone active est de type de conductivité n. Le tableau II donne des valeurs des éléments pour la mise en oeuvre de cet étage amplificateur dans cet exemple.

Avec un étage formé des éléments conformes au tableau II et la structure de la figure 1a, on a obtenu le gain représenté sur les courbes $A_1$ et $A_2$ de la figure 1b. Entre 10 et 30 GHz, on constate une augmentation du gain MAG de 2 dB à 25 GHz, ce qui correspond à une augmentation de la largeur de la bande passante d'environ 3 GHz.

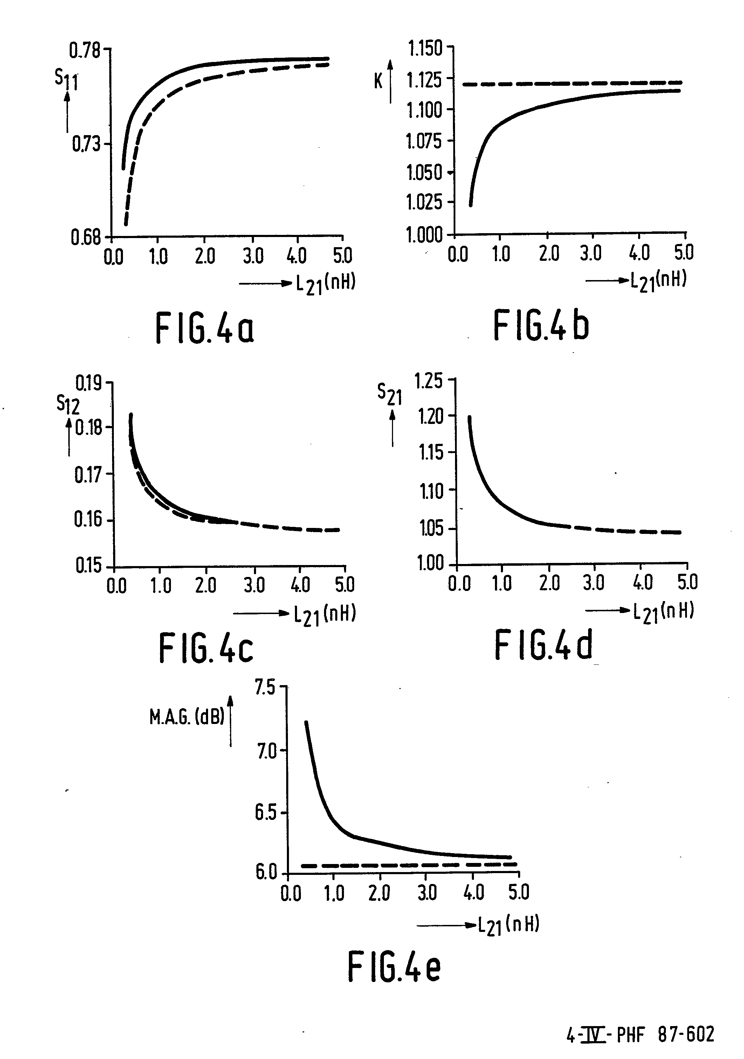

L'ensemble des figures 4 illustre l'évolution des différents paramètres d'un transistor lorsqu'il est chargé selon l'invention (courbes en trait continu) vis-à-vis des mêmes paramètres d'un transistor non chargé ou chargé comme connu de l'état de la technique (courbes en trait discontinu), à une fréquence F = 35 GHz. Notamment :

- la figure 4a représente les variations du coefficient de réflexion $S_{11}$ en fonction de valeurs de l'inductance $L_{21}$ ;

- la figure 4b représente les variations du coefficient de stabilité K en fonction de $L_{21}$ ;

- les figures 4c et 4d représentent les variations des coefficients de transfert $S_{12}$ et $S_{21}$ en fonction de $L_{21}$ ;
 - la figure 4e montre les variations du MAG en fonction de $L_{21}$.

On notera que le coefficient de stabilité du dispositif selon l'invention est légèrement plus faible que dans les dispositifs connus, mais que ce coefficient reste bien supérieur à 1. Le circuit selon l'invention reste donc inconditionnellement stable.

Le transistor utilisable pour réaliser le circuit selon l'invention n'est pas limité au transistor représenté sur la figure 1a.

On peut utiliser d'une façon générale un transistor à N doigts de grille entre lesquels sont disposés (N-1) doigts de drain. Ces structures interdigitées sont choisies pour le fonctionnement en hyperfréquences.

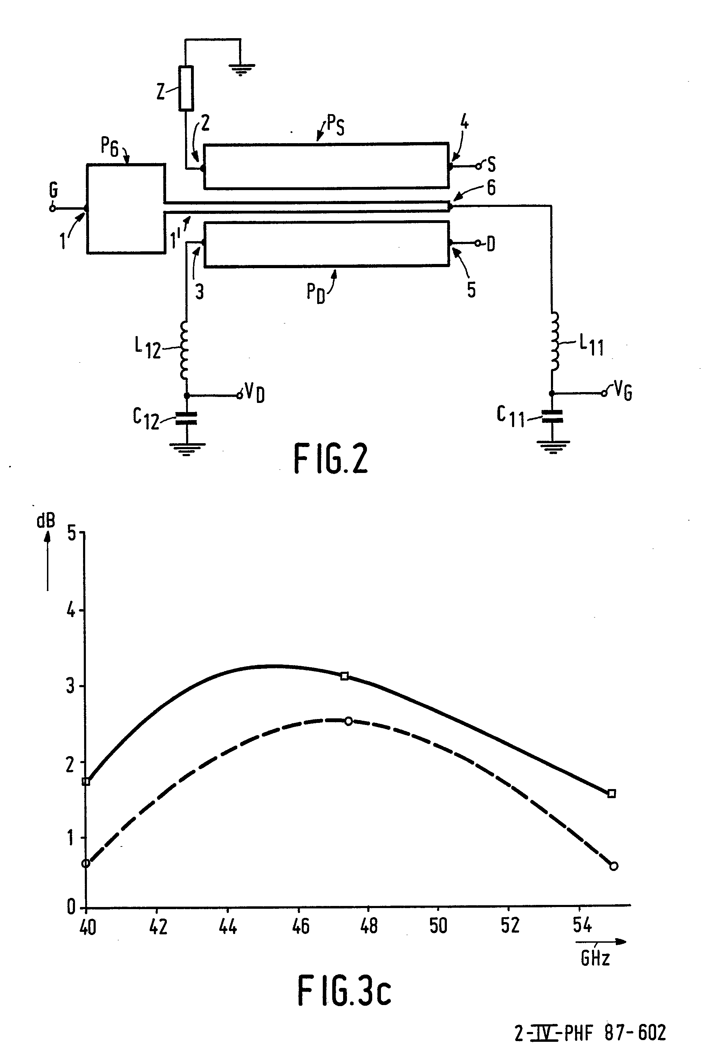

Pour un fonctionnement à des fréquences plus basses, on peut utiliser aussi un transistor à un doigt de grille, tel que représenté sur la figure 2. Le transistor de la figure 2 comprend, formés sur la zone active, un doigt de grille relié à une extrémité $1'$ à un plot de contact $P_G$ de grande surface sur lequel est appliqué en 1 le signal d'entrée hyperfréquences I, et de part et d'autre du doigt de grille un plot de source $P_S$ et un plot de drain $P_D$ de formes allongées parallèlement au doigt de grille, respectivement entre les points 2 et 4, et 3 et 5.

Selon l'invention la grille est fermée à son extrémité 6 opposée au plot $P_G$, sur un circuit LC formé de $L_{11}$ et $C_{11}$, tel que déjà décrit dans le cas des structures interdigitées.

Le signal de sortie hyperfréquences 0 de l'étage est prélevé au point 5 du plot de drain $P_D$ opposé à la position du plot de grille $P_G$. La polarisation de drain est appliquée à l'autre extrémité 3 du plot de drain $P_D$, par l'intermédiaire d'un circuit LC comprenant $L_{12}$ et $C_{12}$, comme déjà décrit dans le cas de la structure interdigitée.

Le signal de source hyperfréquences peut être prélevé au point 4 du plot de source $P_S$ opposé à la position du plot de grille $P_G$. Une charge Z du même type que déjà décrit dans le cas des structures interdigitées peut être appliquée au point 2 du plot $P_S$, et par ailleurs reliée à la masse.

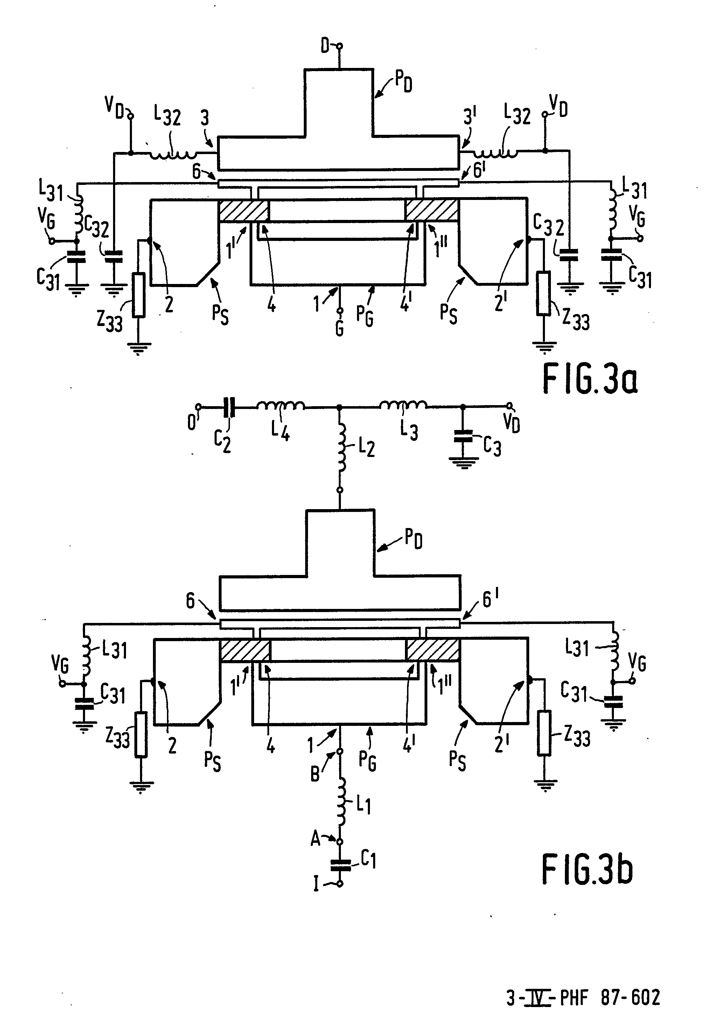

Dans une variante du dispositif selon l'invention, représentée sur la figure 3a, le transistor comprend, formée sur la zone active une électrode de drain allongée entre les points 3 et $3'$, et reliée en son milieu à un plot de contact de grande surface $P_D$ sur lequel est prélevé le signal de sortie hyperfréquences 0 de l'étage ; une électrode de grille en forme de doigt qui s'étend parallèlement au drain entre les poits 6 et $6'$, et est relié symétriquement, aux points $1'$ et $1''$ à un plot de contact de grille $P_G$ de grande surface sur lequel est appliqué le signal d'entrée hyperfréquences au point 1 ; et une électrode de source qui s'étend parallèlement à la grille et du côté opposé au drain, entre les points 4 et $4'$ chacun de ces points étant relié symétriquement à un plot de source $P_S$.

Pour un tel dispositif, les moyens de l'invention seront mis en oeuvre en appliquant un circuit de polarisation de drain $L_{32}$, $C_{32}$ aux extrémités 3 et $3'$ de l'électrode de drain, la tension continue de polarisation de drain $V_D$ étant appliquée au point commun de l'inductance $L_{32}$ et de la capacité $C_{32}$ ; en appliquant un circuit de polarisation de grille $L_{31}$, $C_{31}$ aux extrémités 6 et $6'$ de l'électrode de grille, la tension continue de polarisation de source $V_G$ étant appliquée au point commun de l'inductance $L_{31}$ et de la capacité $C_{31}$ ; et en portant la source à la masse à travers les charges $Z_{33}$ appliquées aux points 2 et $2'$.

Dans le dispositif de la figure 3a, l'inductance $L_{32}$ ne participe pas à l'amélioration du gain et peut donc être disposée soit comme montré sur cette figure, soit de toute manière connue de l'état de la technique.

La figure 3b montre un étage amplificateur réalisé au moyen d'un transistor chargé selon l'invention, du type du transistor de la figure 3a. Ce circuit amplificateur est donné ici seulement à titre d'exemple de réalisation. Les éléments $L_1$, $L_2$, $L_3$, $L_4$ sont des lignes de transmission du type "microstrip". Les éléments $C_1$, $C_2$, $C_3$ $C_{31}$ sont des capacités de découplage. L'élément $L_{31}$ est une ligne de transmission dont l'inductance vaut l'inductance définie selon l'invention (voir la relation 5 du tableau I).

Selon l'art antérieur, il était connu dans un tel amplificateur de connecter les éléments $L_{31}$ et $C_{31}$ non pas aux points 6 et $6'$, mais soit au point A, soit au point B. En opérant de cette façon connue, avec des valeurs des éléments données au tableau III, on obtenait la courbe de gain en fonction de la fréquence représentée en trait discontinu sur la figure 3c. au contraire selon l'invention en disposant les éléments $L_{32}$ et $C_{32}$ aux points 6 et $6'$, on obtient, en gardant par ailleurs les mêmes valeurs pour les différents éléments, la courbe de gain représentée en trait continu sur la figure 3c.

Pour tous ces montages, d'une façon générale l'invention permet d'obtenir les avantages suivants :
- le gain maximal de l'étage est augmenté sur une large bande de fréquences ;
- la fréquence de coupure de l'étage n'est plus limitée par les pertes résistives de la grille ;
- les performances des amplificateurs sont améliorées et ceci particulièrement en hautes fréquences ;
- les circuits de polarisation de grille et de drain sont intégrés mondithiquement avec le transistor ;

- une meilleure adaptation de l'entrée et de la sortie du transistor est réalisée ;
- l'invention n'est pas limitée aux transistors décrits plus haut ; elle peut être appliquée à des transistors de formes différentes réalisés au moyen de technologies diverses, tels que des transistors à effet de champ du type MESFET ou HEMT, réalisés aussi bien en technologie hybride que monolithiquement intégrée.

Les performances obtenues avec les circuits selon l'invention, tels que représentés sur les figure 1a, 2, et 3a, dépendent respectivement de la valeur des inductances $L_{21}$, $L_{11}$ et $L_{31}$.

Si l'on considère que le transistor présente une entrée une capacité $C_e$ connectée à une résistance $R_g$, qui est la résistance de métallisation de l'électrode de grille, la valeur de l'inductance qui devra être placée à l'extrémité opposée à celle où est appliqué le signal hyperfréquences est donnée par la relation 5 du tableau I dans laquelle $\omega$ est la pulsation du signal hyperfréquences.

## TABLEAU I

$$K = (1 + |S_{11} S_{22} - S_{12} S_{21}|^2 - |S_{11}|^2 - |S_{22}|^2)/2|S_{12}| \cdot |S_{21}| \quad (1)$$

$$MAG = K - \sqrt{K^2 - 1} \cdot \left| \frac{S_{21}}{S_{12}} \right| \quad (2)$$

$$MSG = \left| \frac{S_{21}}{S_{12}} \right| \quad (3)$$

$$Z = R + j Y \quad (4)$$

$$L = \frac{1}{2} \left[ \frac{3}{C_e \omega^2} + \frac{1}{\omega} \left( \frac{9}{C_e^2 \omega^2} + R_g^2 \right)^{1/2} \right] \quad (5)$$

## TABLEAU II

| |
|---|
| $\ell$ = 0,5 $\mu$m en moyenne (0,2 $\mu$m $\leq \ell$ $\leq$ 1 $\mu$m) <br> L = 100 $\mu$m pour chaque doigt de grille <br> $V_T$ = - 3V (tension de seuil du transistor) <br> $I_{DS} \approx$ 50 mA |
| Les conditions de polarisations étaient : |

| | |
|---|---|
| $V_D \approx$ 3V <br> $Z_{23} = Z'_{23} = 0$ <br> $L_{22}$ = 0,5 nH <br> $C_{22} = C_{21}$ = 15 pF | $V_G \approx$ - 1V <br><br> $L_{21}$ = 2,5 nH |

TABLEAU III

| $L_1$ = 0,15 nH | $C_1 = C_2 = C_3 = C_{31}$ = 2 pF |
|---|---|
| $L_2$ = 0,12 nH | |
| $L_3$ = 0,2 nH | $Z_{33}$ = 0,2 + j9 (ohms) |
| $L_4$ = 0,04 nH | |

**Revendications**

1. Circuit hyperfréquences comprenant au moins un transistor à effet de champ, constitué, en contact avec une zone active, d'électrodes de grille, de drain et de source, l'électrode de grille recevant un signal d'entrée hyperfréquences, et les électrodes de source et drain fournissant des signaux de sortie hyperfréquences, les électrodes de grille et de drain étant en outre munies de circuits de polarisation et de charge, et l'électrode de source étant reliée à la masse à travers une charge, caractérisé en ce que, les signaux hyperfréquences sont appliqués ou disponibles à une extrémité de leurs électrodes respectives, lesquelles sont par ailleurs fermées à leur seconde extrémité par leurs circuits de polarisation ou de charge respectifs.

2. Circuit selon la revendication 1, dans lequel le transistor à effet de champ est constitué d'une électrode de grille à un doigt de part et d'autre duquel sont réalisées l'électrode de source et l'électrode de drain, l'électrode de grille étant reliée par une de ses extrémités à un plot de contact de grande surface, caractérisé en ce que le signal d'entrée hyperfréquence est appliqué sur le plot de grille et l'autre extrémité du doigt de grille est fermée sur le circuit de polarisation et de charge de grille, en ce que les signaux de sortie hyperfréquences sont prélevés à l'extrémité des électrodes de source et drain opposée longitudinalement à la position du plot de grille, et en ce que les secondes extrémités de ces électrodes de source et drain sont respectivement fermées sur une charge par ailleurs reliée à la masse et sur le circuit de polarisation et de charge de drain.

3. Circuit ·selon la revendication 1, dans lequel le transistor à effet de champ est constitué. d'une électrode de grille à N doigts disposés parallèlement, d'une électrode de drain à (N-1) disposés parallèlement chacun entre deux doigts de grille, et d'une électrode de source comportant deux contacts disposés de part et d'autre de l'ensemble grille-drain, les extrémités dites premières extrémités des doigts de grille étant reliées entre elles et à un plot de contact de grande surface, les extrémités dites premières extrémités des doigts de drains, longitudinalement opposées à la position du plot de contact de grille, étant reliées entre elles et à un plot de contact de grande surface, caractérisé en ce que le signal d'entrée hyperfréquence est appliqué sur le plot de grille, et les autres extrémités dites secondes extrémités des doigts de grilles sont reliées entre elles et fermées sur le circuit de polarisation et de charge de grille, en ce que le signal de sortie hyperfréquences de drain est prélevé sur le plot de drain, et les autres extrémités dites secondes extrémités des doigts de drain sont reliées entre elles et fermées sur le circuit de polarisation et de charge de drain et en ce que le signal de sortie hyperfréquences de source est prélevé sur l'une ou l'autre électrode de source à son extrémité dite première extrémité opposée au plot de grille et les autres extrémités dites secondes extrémités sont reliées entre elles et fermées sur une charge par ailleurs reliée à la masse.

4. Circuit selon la revendication 3 caractérisé en ce que la charge appliquée sur lesdites secondes extrémités des électrodes de source est formée de deux charges symétriques.

5. Circuit selon la revendication 1, dans lequel le transistor à effet de champ est consitué d'une électrode de grille à un doigt de part et d'autre duquel sont réalisées l'électrode de source et l'électrode de drain, l'électrode de grille étant reliée par chacune de ses extrémités de façon symétrique à un plot de grande surface, l'électrode de source étant reliée par chacune de ses extrémités de façon symétrique à deux plots de grande surface, et l'électrode de drain étant reliée par son milieu à un plot de grande surface, caractérisé en ce que le signal d'entrée hyperfréquences est appliqué sur le plot de grille, en ce que les extrémités du doigt de grille sont reliées de façon symétrique à des circuits de plarisation et de charge de grille, en ce que le signal de sortie hyperfréquences est prélevé sur le plot de drain, et en ce que les extrémités de l'électrode de source sont reliées à la masse à travers des charges symétriques.

6. Circuit selon la revendication 5, caractérisé ence que les circuits de polarisation et de charge de drain sont appliqués à chaque extrémité de l'électrode de drain.

7. Circuit selon la revendication 5, caractérisé en ce que les circuits de polarisation et de charge de drain sont appliqués sur le plot de drain.

8. Circuit selon l'une des revendications précédentes, caractérisé en ce que les circuits de polarisation et de charge de grille et drain sont formés chacun d'une inductance portée à la masse à travers une capacité d'isolation en continue, et en ce qu'une tension continue de polarisation respectivement de grille et de drain est appliquée au point commun de l'inductance et de la capacité.

9. Circuit selon la revendication 8, caractérisé en ce que dans le circuit de polarisation et de charge de grille, cette inductance L a une valeur voisine de :

$$L = \frac{1}{2} \left[ \frac{3}{C_e \omega^2} + \frac{1}{\omega} \left( \frac{9}{C_e^2 \omega^2} + R_g^2 \right)^{1/2} \right] \qquad (5)$$

relation dans laquelle $C_e$ est la capacité d'entrée du transistor, $R_g$ est la résistance de métallisation de grille et $\omega$ est la pulsation du signal hyperfréquences.

10. Circuit selon l'une des revendications précédentes, caractérisé en ce qu'il est monolithiquement intégré sur un substrat semi-isolant en arséniure de gallium (GaAs) et en ce que la zone active est de type de conductivité n.

11. Circuit selon la revendication 10, caractérisé en ce que l'électrode de grille du transistor à effet de champ est de type Schottky et les électrodes de source et drain des contacts ohmiques.

**FIG.1a**

**FIG.1b**

# FIG.2

# FIG.3c

FIG.3a

FIG.3b

FIG.4a

FIG.4b

FIG.4c

FIG.4d

FIG.4e

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | IEEE TRANSACTIONS ON MICROWAVE THEORY AND TECHNIQUES, vol. MTT-35, mai 1987, pages 487-491, IEEE, New York, US; W. HEINRICH: "Distributed equivalent-circuit model for traveling-wave FET design" * Figures 1,2,4; page 487, colonne de droite, lignes 4-28; page 489, paragraphe III: "Wave progapation analysis" * | 1,10,11 | H 03 F 3/60 |
| Y | US-A-4 486 719 (Y. AYASLI) * Figure 1; résumé * | 1,10,11 | |
| A | | 6,8 | |
| D,A | ACTA ELECTRONICA, vol. 23, no. 2, 1980, pages 123,124; P. BAUDET: "Les transistors à effect de champ de puissance en GaAs: conception et technologie" * Pages 123,124; figure 7 * | 2,3 | |

DOMAINES TECHNIQUES RECHERCHES (Int. Cl.4)

H 03 F

Le présent rapport a été établi pour toutes les revendications

| Lieu de la recherche | Date d'achèvement de la recherche | Examinateur |
|---|---|---|
| LA HAYE | 16-03-1989 | TYBERGHIEN G.M.P. |

EPO FORM 1503 03.82 (P0402)